# EUROPÄISCHE PATENTANMELDUNG

(11) **EP 1 624 353 A2**
(43) Veröffentlichungstag der Anmeldung: **08.02.2006**
(21) Anmeldenummer: 05105098.7
(22) Anmeldetag: 10.06.2005
(51) Int. Cl.: G05B 19/414

(54) **Verfahren zur synchronen Steuerung oder Regelung einer Schaltungseinheit mit pulsweitenmodulierten Signalen und Steuerungs- oder Regelungseinheit hierzu**

(30) Priorität: 04.08.2004 DE 102004037737
(71) Anmelder: Continental Aktiengesellschaft, 30165 Hannover (DE)
(72) Erfinder: Schünemann, Werner, 29308 Winsen (DE); König, Oliver, 30171 Hannover (DE)

(57) **Zusammenfassung**

Ein Verfahren zur synchronen Steuerung oder Regelung einer Schaltungseinheit mit pulsweitenmodulierten Signalen, wobei ein gemessener Strom oder eine gemessene Spannung (Uₘₑₛₛ) des PWM-Signals als Istgröße zur Steuerung oder Regelung dient, hat die Schritte von:
- Generieren von Interruptsignalen mit vorrangiger Priorität vor anderen Interruptsignalen in Abhängigkeit von einem Referenzsignal, das synchron zu mindestens einem der pulsweitenmodulierten Signale ist;
- Messen des Stroms und/oder der Spannung (Uₘₑₛₛ) mindestens eines der pulsweitenmodulierten Signale als Istgröße nach einer definierten Verzögerungszeit; und
- Starten des Steuerungs- oder Regelungsvorgangs mit der gemessenen Istgröße durch Generieren eines Interruptsignals unmittelbar nach Abschluss der Messung.

## Beschreibung

Die Erfindung betrifft ein Verfahren zur synchronen Steuerung oder Regelung einer Schaltungseinheit mit pulsweitenmodulierten Signalen, wobei ein gemessener Strom oder eine gemessene Spannung des pulsweitenmodulierten Signals als Istgröße zur Steuerung oder Regelung dient.

Die Erfindung betrifft weiterhin eine Steuerungs- oder Regelungseinheit zur synchronen Steuerung oder Regelung einer Schaltungseinheit mit pulsweitenmodulierten Signalen mit einem solchen Verfahren.

Zur Reduzierung von Verlustleistung bei induktiven Lasten, wie zum Beispiel Relais, ist bekannt, diese mittels eines pulsweitenmodulierten Signals anzusteuern. Dabei stellt sich der mittlere Strom nach einer Exponential-Funktion ein.

Beispielsweise zur Stromregelung ist für eine Schaltungseinheit erforderlich, den sich einstellenden mittleren Strom zeitnah zu messen und als Istgröße zu nutzen. Wenn als Endstufe einer angesteuerten Schaltungseinheit ein so genannter Lowside-Schalter verwendet wird, kann ein Strom allerdings nur während der eingeschalteten Phase des pulsweitenmodulierten Signals (PWM-Signal) gemessen werden. Während der abgeschalteten Phase des pulsweitenmodulierten Signals fließt der Strom durch die Spule der induktiven Last über eine Freilaufdiode.

Die Erzeugung der pulsweitenmodulierten Signale erfolgt herkömmlicherweise mit Mikrocontrollern, die eine unabhängige PWM-Einheit zur Erzeugung eines pulsweitenmodulierten Signals mit geringem Softwareaufwand haben. Die Flanken des pulsweitenmodulierten Signals sind jedoch asynchron zum weiteren Programmablauf, so dass eine zum pulsweitenmodulierten Signal synchrone Analog-/Digitalumsetzung, Messung und Steuerung bzw. Regelung nicht alleine durch Software ausgelöst werden kann.

Es ist bekannt, den aus dem pulsweitenmodulierten Signal resultierenden Strom so stark zu filtern, das näherungsweise ein dem Gesamtstrom proportionales Signal entsteht. Dies führt zu einer sehr geringen zeitlichen Dynamik und ist trotzdem ungenau, da die Filterung auch das jeweilige Tastverhältnis berücksichtigen muss.

Es ist auch bekannt, mit aufwendigeren Endstufen eine Strommessung auch während der nicht aktiven Phase des pulsweitenmodulierten Signals durchzuführen. Die Stromwerte müssen dennoch gefiltert werden, da der Stromverlauf je nach Schaltzustand nach einer Exponential-Funktion erfolgt. Die aufwendigeren Endstufen sind nachteilig mit höheren Kosten verbunden. Zudem ist auf Grund der Filterung die Dynamik verringert.

Weiterhin ist bekannt, das pulsweitemodulierte Signal nicht mit einer PWM-Einheit, sondern durch softwaremäßige Ansteuerung von sogenannten Portpins zu generieren. Hierdurch ist eine zum pulsweitenmodulierten Signal synchrone Strommessung möglich. Der Rechenzeitbedarf ist dabei jedoch erhöht. Zudem ergibt sich ein verstärkter Jitter bereits im pulsweitenmodulierten Signal, da die Flanken des pulsweitenmodulierten Signals durch Timer-Interrupts eines Taktgebers generiert werden müssen.

Weiterhin ist bekannt bei Verwendung eines so genannten Capture-Eingangs eines Mikrocontrollers durch Hardwaresteuerung beim Auftreten einer Flanke eines pulsweitenmodulierten Signals einen Zeitstempel zu speichern. In einer eventuell verzögerten Interrupt-Service-Routine kann damit die Verzögerung bis zum eigentlichen Messzeitpunkt ermittelt und als Korrekturfaktor bei der Strommessung berücksichtigt werden. Die Verzögerung der Messung selbst kann allerdings nicht verhindert werden und die nachträgliche Korrektur erhöht die Komplexität von Software zur Steuerung des Mikrocontrollers erheblich.

Aufgabe der Erfindung ist es daher, ein verbessertes Verfahren zur synchronen Steuerung oder Regelung einer Schaltungseinheit mit pulsweitenmodulierten Sig nalen zu schaffen, wobei ein gemessener Strom oder eine gemessene Spannung des pulsweitenmodulierten Signals als Istgröße zur Steuerung oder Regelung dient.

Aufgabe der Erfindung ist es weiterhin, eine verbesserte Steuerungs- oder Regelungseinheit zur synchronen Steuerung oder Regelung einer Schaltungseinheit mit pulsweitenmodulierten Signalen mit einem solchen Verfahren zu schaffen.

Die Aufgabe wird mit dem gattungsgemäßen Verfahren erfindungsgemäß gelöst durch
- Generieren von Interruptsignalen mit vorrangiger Priorität vor anderen Interruptsignalen in Abhängigkeit von einem Referenzsignal, das synchron zu mindestens einem der pulsweitenmodulierten Signale ist,
- Messen des Stroms und/oder der Spannung mindestens einer der pulsweitenmodulierten Signale als Istgröße nach einer defmierten Verzögerungszeit, und
- Starten des Steuerungs- oder Regelungsvorgangs mit der gemesenen Istgröße durch Generieren eines Interruptsignals unmittelbar nach Abschluss der Messung.

Es wird vorgeschlagen, ein zu den verwendeten pulsweitenmodulierten Signalen in der Frequenz synchrones PWM-Referenzsignal zu generieren. Durch eine Verknüpfung des PWM-Referenzsignals mit einem speziellen Interrupt mit vorrangiger Priorität wird es ermöglicht, nahezu ohne Jitter eine Messung synchron zu dem mindestens einen pulsweitenmodulierten Signal auszulösen. Beim Ende der Messung wird dann durch ein weiteres Interruptsignal unmittelbar der Steuerungs- oder Regelungsvorgang gestartet, beispielsweise durch Aufruf eines Stromreglers, so dass die Istgrößen für die Steuerung oder Regelung immer aktuell sind. Die Aufrufhäufigkeit der Steuerung oder Regelung wird durch die Frequenz des pulsweitenmodulierten Signals vorgegeben.

Vorzugsweise erfolgt ein zeitlich gegeneinander verschobenes Messen des Stroms und/oder der Spannung von pulsweitenmodulierten Signalen auf mindestens zwei getrennten PWM-Kanälen, wobei die Zeitverschiebung konstant ist und so festgelegt ist, dass die Messung im annähernd eingeschwungenem Bereich des jeweiligen pulsweitenmodulierten Signals erfolgen.

Durch die festgelegte Verzögerung der Messung vom Zeitpunkt des durch das PWM-Referenzsignal ausgelösten Interruptsignals mit vorrangiger Priorität bis zum Messzeitpunkt wird der PWM-Referenzkanal mit dem PWM-Referenzsignal gegenüber den verwendeten PWM-Kanälen so verschoben, dass der Messzeitpunkt möglichst weit hinten im Signalverlauf liegt. Dabei muss allerdings berücksichtigt werden, dass der Messzeitpunkt auch bei minimaler Pulsbreite noch in der Einschaltphase liegt, da in der Regel nur dann ein Strom, beispielsweise durch einen Messwiderstand der Schaltungseinheit fließt.

Vorzugsweise erfolgt eine Analog-/Digital-Wandlung der gemessenen Istgröße und ein Festlegen der Zeitverschiebung zwischen den Messungen der pulsweitenmodulierten Signale auf den PWM-Kanälen, wobei die Zeitverschiebung der Zeitdauer für die Analog-/Digital-Wandlung entspricht. Durch diese Verzögerung wird die Dauer der Analog-/Digital-Wandlung ausgeglichen, und es wird sichergestellt, dass der Messzeitpunkt bezogen auf die Flanke der pulsweitenmodulierten Signale bei allen PWM-Kanälen identisch ist.

Hierbei erfolgt bevorzugt ein Generieren eines Interruptsignals am Ende der Analog-/Digital-Wandlung zum Starten des Steuerungs- oder Regelungsvorgangs, so dass die Steuerung bzw. Regelung unmittelbar nach der Messung und Analog-/Digital-Wandlung mit aktueller Stell- oder Führungsgröße und Istgröße erfolgen kann.

Weiterhin ist es vorteilhaft, die pulsweitenmodulierten Signale synchron zu einem gemeinsamen Taktsignal derart zu generieren, dass eine Phasenverschiebung mehrerer PMW-Kanäle konstant ist. Andernfalls ist auf andere Weise dafür Sorge zu tragen, dass die Phasenverschiebung der pulsweitenmodulierten Signale auf den PWM-Kanälen während des Betriebs nicht variiert.

Die Aufgabe wird weiterhin mit der gattungsgemäß Steuerungs- oder Regelungseinheit gelöst durch einen interruptgesteuerten Mikrocontroller zur Erzeugung von pulsweitenmodulierten Signalen, wobei eine Interruptsteuerung des Mikrocontrollers mit einem PWM-Referenzsignal, das synchron zu dem mindestens einen pulsweitenmodulierten Signal ist, beaufschlagbar ist, um mit vorrangiger Priorität eine Messung des Stroms und/oder der Spannung als Istgröße mindestens eines der pulsweitenmodulierten Signale und einer definierten Verzögerungszeit auszulösen.

Vorzugsweise ist die mit pulsweitenmodulierten Signalen angesteuerte Schaltungseinheit eine Endstufe mit mindestens einer induktiven Last.

Die Erfindung wird nachfolgend anhand der beigefügten Zeichnungen beispielhaft näher erläutert. Es zeigen:
- Figur 1 -: Blockdiagramm einer Regelungseinheit zur Regelung einer mit pulsweitenmodulierten Signalen gesteuerten Schaltungseinheit mit Endstufe und induktiven Lasten;
- Figur 2 -: Schaltbild einer beispielhaften Schaltungseinheit mit Endstufe und induktiver Last;
- Figur 3 -: Diagramm eines pulsweitenmodulierten Signals und des resultierenden Stroms bei induktiver Last;
- Figur 4 -: Zeitdiagramm eines PWM-Referenzsignals und von drei pulsweitenmodulierten Signalen für ein erstes, zweites und drittes Ventil;
- Figur 5 -: Steuerungsebenen einer Steuerungs- oder Regelungseinheit mit einem Zeitdiagramm einzelner Aktionen.

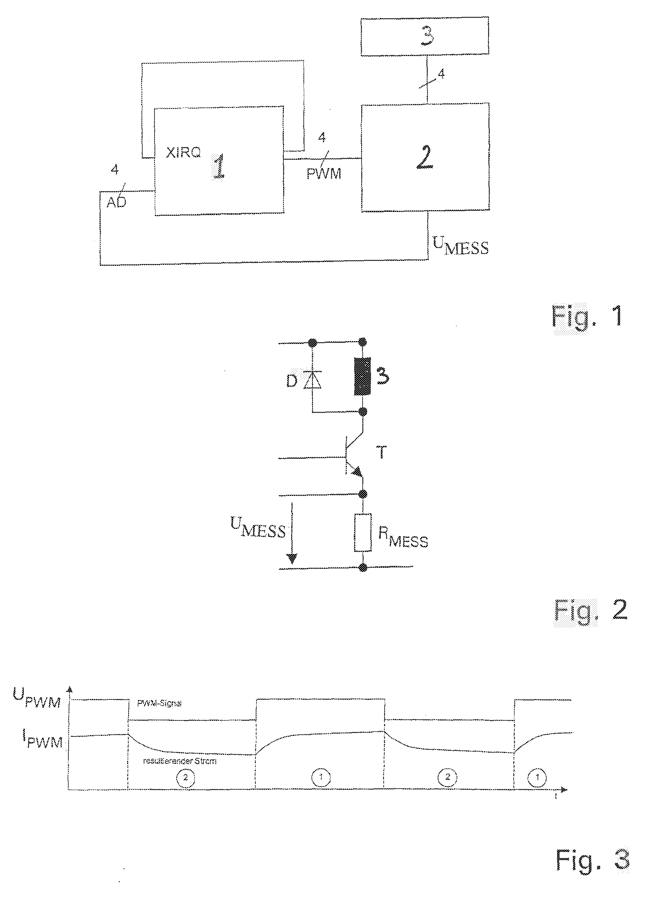

Die Figur 1 lässt ein Blockdiagramm einer Regelungseinheit mit einem interruptgesteuerten Mikrocontroller 1 erkennen, der pulsweitenmodulierte (PWM) Sig nale an eine Endstufe 2 zur Steuerung von induktiven Lasten 3 überträgt. Der Mikrocontroller 1 hat eine Vielzahl von PWM-Kanälen, von denen im dargestellten Beispiel nur vier PWM-Kanäle zur Steuerung von induktiven Lasten 3, wie zum Beispiel von Ventilen
oder Relais verwendet werden. Ein ungenutzter PWM-Kanal wird als PWM-Referenzkanal verwendet. Dieser PWM-Referenzkanal wird so konfiguriert, dass das PWM-Referenzsignal synchron zu den pulsweitenmodulierten Signalen der verwendeten PWM-Kanäle ist. Der PWM-Referenzkanal wird elektrisch mit dem Eingang XIRQ des Mikrocontrollers 1 verbunden. Ein Signal am Eingang XIRQ löst einen Interrupt mit vorrangiger Priorität aus, so dass ein durch den Interrupt angestoßener Prozess bevorzugt vor allen anderen Prozessen durchgeführt wird. Ein an dem Eingang XIRQ anliegendes Interruptsignal führt somit dazu, dass andere Interrupt-Service-Routinen unterbrochen werden.

Nach Generieren des Interruptsignals mit vorrangiger Priorität wird gegebenenfalls nach einer Verzögerungszeit in der Endstufe 2 die Messspannung Uₘₑₛₛ der PWM-Signale in den PWM-Kanälen gemessen, die proportional zum Strom sind. Die Messspannung U_{MESS} wird mit einem Analog-/Digital-Wandler in ein vom Mikrocontroller 1 auswertbares Signal umgewandelt.

Unmittelbar anschließend wird durch den Mikrocontroller 1 softwaregesteuert ein Regelungsvorgang angestoßen, um mit der zum Strom proportionalen Messspannung U_{MESS} als Führungsgröße eine Stromregelung der pulsweitenmodulierten Signale durchzuführen.

Entscheidend ist, dass das PWM-Referenzsignal so konfiguriert ist, dass das PWM-Referenzsignal synchron zu den PWM-Signalen der ver-wendeten PWM-Kanäle ist.

Der Analog-/Digital-Wandler des Mikrocontrollers 1 sollte so konfiguriert sein, dass alle Analog-Kanäle des mit der Endstufe 2 verbundenen Mikrocontrollers1 sequenziell nacheinander eingelesen werden. Da die Analog-/Digital-Wandlung pro Analog-Kanal eine feste Zeit dauert, kann genau ermittelt werden, zu welchem Zeitpunkt die Wandlung stattfindet.

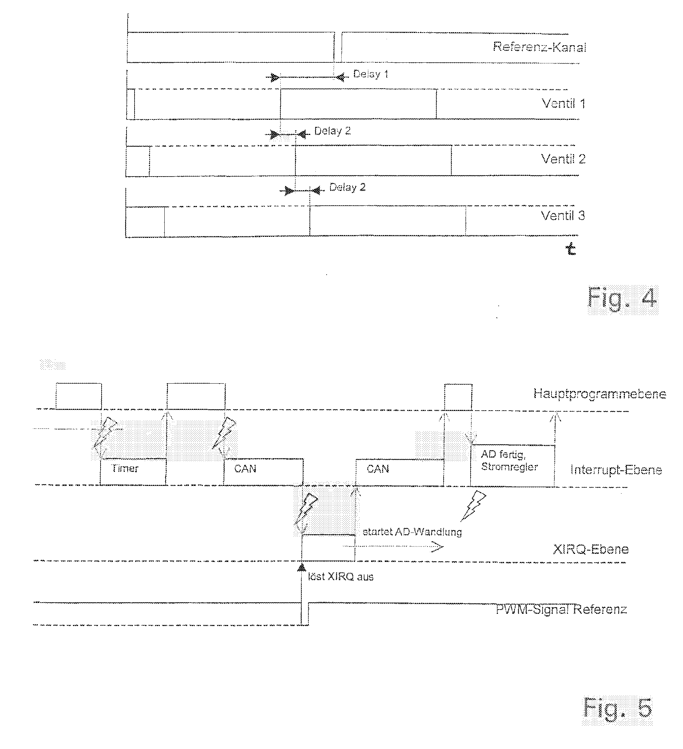

Die Figur 2 lässt ein Schaltbild der Endstufe 2 mit induktiver Last 3 erkennen. Die Endstufe 2 hat einen Lowside-Schalter T und den erwähnten Messwiderstand R_{MESS} zum Abgriff einer zum Strom des PWM-Signals proportionalen Messspannung U_{MESS}. Es ist weiter erkennbar, dass parallel zur induktiven Last 3 eine Freilaufdiode D geschaltet ist.

Die Figur 3 lässt ein Diagramm eines PWM-Signals U_{PWM} und des resultierenden Stroms I_{PWM} über die Zeit t erkennen. Es wird deutlich, dass im Fall (1) ein Stromfluss durch den Lowside-Schalter T mit der Folge eines nach einer Exponentialfunktion ansteigenden mittleren Stroms erfolgt. Während der abgeschalteten Phase des PWM-Signals klingt der resultierende Strom I_{PWM} nach einer Exponentialfunktion ab (Phase (2)).

Die Figur 4 lässt ein Zeitdiagramm der an dem PWM-Referenzkanal und drei PWM-Kanälen für ein erstes, ein zweites und ein drittes Ventil anliegenden PWM-Signale erkennen. Es wird deutlich, dass eine Verzögerung Delay 1 bis zum Messzeitpunkt festgelegt ist, um den PWM-Referenzkanal gegenüber den verwendeten PWM-Kanälen so zu verschieben, dass der Zeitpunkt möglichst weit hinten im Signalverlauf der PWM-Signale liegt. Dabei muss allerdings berücksichtigt werden, dass der Messzeitpunkt auch bei minimaler Pulsbreite noch in der Anschaltphase liegt, da nur dann Strom durch den Messwiderstand R_{MESS} fließt.

Eine weitere Zeitverschiebung Delay 2 gleicht die Dauer der Analog-/Digital-Wandlung aus. Die genutzten PWM-Kanäle sind genau um die Zeitdauer der Analog-/Digital-Wandlung gegeneinander verschoben, so dass der Messzeitpunkt bezogen auf die PWM-Flanke der PWM-Signale bei allen PWM-Kanälen identisch ist. Das Generieren des Interruptsignals am Eingang XIRQ und damit die Messung der Istgröße findet bei Low-Pegel des PWM-Referenzsignals statt. Wesentlich ist dabei ist, dass die Phasenverschiebung der PWM-Kanäle während des Betriebs nicht variiert. Da die PWM-Signale bei dem dargestellten Mikrocontroller 1 aus einem einzigen Taktgeber generiert wird, ist das der Fall.

Die Figur 5 lässt ein Diagramm der Hauptprogrammebene, Interruptebene, XIRQ-Ebene des Mikroprozessors 1 und der Ebene des PWM-Signals über die Zeit t erkennen. Es wird deutlich, dass ein Impuls des PWM-Referenzsignals ein Interruptsignal XIRQ mit vorrangiger Priorität auslöst, das die Messung einer Istgröße anstößt. Nach durchgeführter Messung wird die Analog-/Digital-Wandlung gestartet.

Das Ende der Analog-/Digital-Wandlung löst ebenfalls einen Interrupt aus. Die Ergebnisse der Analog-/Digital-Wandlung werden in der Interrupt-Service-Routine des Analog-/Digital-Wandlers ausgelesen und der eigentliche Stromregler direkt aufgerufen. Der Stromregler arbeitet somit mit möglichst aktuellen Istgrößen. Eine Verzögerung des Analog-/Digital-Interrupts auf Grund von gerade aktiven anderen Interrupt-Service-Routinen, wie zum Beispiel ein CAN-Empfang auf einem CAN-Bus, kann nicht verhindert werden. Dieses ist jedoch auch nicht kritisch, da der Zeitpunkt des Einlesens der Werte synchron zu dem PWM-Signalen stattfinden muss.

Allerdings ist erforderlich, dass das Interruptsignal mit vorrangiger Priorität XIRQ andere Interrupts unterbrechen kann. Nur dann ist gewährleistet, dass es zu keinem Jitter bei der Messung kommt.

## Patentansprüche

1. Verfahren zur synchronen Steuerung oder Regelung einer Schaltungseinheit mit pulsweitenmodulierten Signalen, wobei ein gemessener Strom oder eine gemessene Spannung (Uₘₑₛₛ) des pulsweitenmodulierten Signals als Istgröße zur Steuerung oder Regelung dient, **gekennzeichnet durch**
- Generieren von Interruptsignalen mit vorrangiger Priorität vor anderen Interruptsignalen in Abhängigkeit von einem Referenzsignal, das synchron zu mindestens einem der pulsweitenmodulierten Signale ist;
- Messen des Stroms und/oder der Spannung (Uₘₑₛₛ) mindestens eines der pulsweitenmodulierten Signale als Istgröße nach einer definierten Verzögerungszeit; und
- Starten des Steuerungs- oder Regelungsvorgangs mit der gemessenen Istgröße **durch** Generieren eines Interruptsignals unmittelbar nach Abschluss der Messung.

2. Verfahren nach Anspruch 1, **gekennzeichnet durch** zeitlich gegeneinander verschobenes Messen des Stroms und/oder der Spannung (Uₘₑₛₛ) von pulsweitenmodulierten Signalen auf mindestens zwei getrennten PWM-Kanälen für pulsweitenmodulierte Signale, wobei die Zeitverschiebung konstant ist und so festgelegt ist, dass die Messungen im annähernd eingeschwungenen Bereich des jeweiligen pulsweitenmodulierten Signals erfolgen.

3. Verfahren nach Anspruch 2, **gekennzeichnet durch** Analog-/Digital-Wandlung der gemessenen Istgröße und Festlegen der Zeitverschiebung zwischen den Messungen der pulsweitenmodulierten Signale auf den PWM-Kanälen so, dass die Zeitverschiebung der Zeitdauer für die Analog-/Digital-Wandlung entspricht.

4. Verfahren nach Anspruch 3, **gekennzeichnet durch** Generieren eines Interruptsignals am Ende der der Analog-/Digital-Wandlung zum Starten des Steuerungs- oder Regelungsvorgangs.

5. Verfahren nach einem der vorhergehenden Ansprüche, **gekennzeichnet durch** Generieren der pulsweitenmodulierten Signale synchron zu einem gemeinsamen Taktsignal derart, dass eine Phasenverschiebung mehrerer PWM-Kanäle konstant ist.

6. Steuerungs- und Regelungseinheit zur synchronen Steuerung oder Regelung einer Schaltungseinheit mit pulsweitenmodulierten Signalen mit dem Verfahren nach einem der vorhergehenden Ansprüche, **gekennzeichnet durch** einen interruptgesteuerten Mikrocontroller (1) zur Erzeugung von pulsweitenmodulierten Signalen, wobei ein Interrupteingang (XIRQ) des Mikrocontrollers (1) mit einem PWM-Referenzsignal, das synchron zu dem mindestens einen pulsweitenmodulierten Signal ist, beaufschlagbar ist, um mit vorrangiger Priorität eine Messung des Stroms und/oder der Spannung (Uₘₑₛₛ) als Istgröße mindestens eines der pulsweitenmodulierten Signale nach einer definierten Verzögerungszeit auszulösen.

7. Steuerungs- oder Regelungseinheit nach Anspruch 6, **dadurch gekennzeichnet, dass** die Schaltungseinheit eine Endstufe (2) mit mindestens einer induktiven Last (3) hat.
